# EUROPEAN PATENT SPECIFICATION

(11) **EP 4 418 843 B1**
(45) Date of publication and mention of the grant of the patent: **04.11.2026**
(21) Application number: 22880484.5
(22) Date of filing: 25.05.2022
(51) Int. Cl.: H10N 30/853, H10N 30/88, H10N 30/01, H10N 30/045, H10N 30/092, H10N 30/097, C04B 35/475

(54) **CERAMIC MATERIAL SHEETS COMPRISING GRAPHITE FOR ENERGY GENERATION AND MANUFACTURING METHOD THEREOF**
GRAPHITHALTIGE KERAMISCHE MATERIALFOLIEN ZUR ENERGIEERZEUGUNG UND HERSTELLUNGSVERFAHREN DAFÜR
FEUILLE EN MATÉRIAU CÉRAMIQUE COMPRENANT DU GRAPHITE POUR LA GÉNÉRATION D'ÉNERGIE ET SON PROCÉDÉ DE FABRICATION

(30) Priority: 13.10.2021 CO 21013685
(43) Date of publication of application: 21.08.2024
(73) Proprietor: CORPORACIÓN UNIVERSITARIA MINUTO DE DIOS - UNIMINUTO, 70 Bogotá (CO)
(72) Inventor: CASTELLANOS BEJARANO, Nobel Eliecer, Bogotá (CO)
(74) Representative: Clarke, Modet y Cía., S.L.
(86) International application number: PCT/IB2022/054892
(87) International publication number: WO 2023/062440

(56) References cited:
- EP-A1- 3 402 064
- CN-A- 106 910 819
- JP-A- 2016 163 027
- KR-B1- 101 261 726
- US-A1- 2008 009 572
- US-A1- 2019 229 255
- SONG, X.T. ET AL.: "Low-frequency plasmonic state and tunable negative permittivity in percolative graphite / barium titanate composites", CERAMICS INTERNATIONAL, vol. 48, no. 1, 16 September 2021 (2021-09-16), pages 832 - 836, XP086865443, ISSN: 0272-8842, DOI: 10.1016/j.ceramint. 2021.09.16 4
- WANG ET AL.: "Electromagnetic properties of carbon black and barium titanate composite materials", JOURNAL OF ALLOYS AND COMPOUNDS, vol. 454, no. 1-2, 18 March 2008 (2008-03-18), pages 340 - 346, XP022540585, ISSN: 0925-8388, DOI: 10.1016/j.jallcom. 2006.12.07 7

## Description

### TECHNICAL FIELD

The present technology is framed within the green technologies of alternative energy and environmentally friendly, since, through it, a material is obtained in the form of sheets that when subjected to mechanical stresses acquire electrical polarization in its mass for the production of clean energy, mainly for road and pedestrian applications from compression and decompression of this type of material.

### PRIOR ART

The search for energy generation other than that produced by fossil fuels has become a primary objective in the current era, mainly due to the eventual depletion of this non-renewable resource and the production of pollution, mainly the emission of greenhouse gases that affect the world's climate, generating the well-known global warming.

In this sense, an alternative energy generation is provided by the piezoelectricity phenomenon presented by some ceramic materials when subjected to mechanical stresses for energy production. In this sense, it is known for example the Colombian patent NC2017/0004741 that reports a piezoelectric material comprising a ferroelectric ceramic material that is composed of a lead-free input.

On the other hand, known is document CN104710174 A showing a lead-free ceramic dielectric material with high density and high voltage properties, wherein the components of the material are expressed by the general formula (0.95-x-y-z) Bi_{0.5}Na_{0.5}TiO₃-xBi_{0.5}K_{0.5}TiO₃-yBa_{0.65}Sr_{0.35}TiO₃-zK_{0.5}Na_{0.5}NbO₃-0.05LiTaO₃ where x, y, z represent the mole fractions; x is greater than or equal to 0.002 and less than or equal to 0.3; y is greater than or equal to 0.002 and less than or equal to 0.2; z is greater than or equal to 0.001 and less than or equal to 0.3. It also shows a process of obtaining the material based on sintering by means of electrical discharge plasma, obtaining a uniform and dense ceramic texture at a low sintering temperature.

Also known is document WO2011/010484 A1 which relates to a piezoelectric body useful as a sensor, actuator, ultrasonic transducer, etc. The piezoelectric body comprises an alternating laminate structure of a layer of an organo onium (G) and a layer of an inorganic phase (MX4) and an inorganic phase (MX4) alternately laminated in layers, or a composite comprising aggregated particles of graphene structure and perovskite structure of an average particle size of not more than 200 nm.

On the other hand, document US5153859 A shows a method for forming a laminated piezoelectric structure in which a plurality of polarized piezoelectric films of vinylidene fluoride and trifluoroethylene are solvent welded together. The solvent welding solution comprises a copolymer of vinylidene fluoride and trifluoroethylene and a suitable solvent. Transducers produced from such a laminated structure are also described. It further teaches that copper strand conductors (26 gauge) are applied to the copper side of each electrode using conventional lead-tin soldering and wiring of a plurality of parallel laminated tiles to form a chain of indefinite length.

For its part, WO2007/143244 A2 teaches a piezoelectric buzzer-type material which includes a vibrating layer capable of withstanding temperatures above 260°C for at least five minutes while maintaining its ability to vibrate and produce a buzz at a level of at least 8OdB, and a high-temperature piezoelectric material having a Curie temperature above 260°C and one or more of the following properties: a planar coupling coefficient (kp) of at least about 0.5; a longitudinal coupling coefficient (k33) of at least about 1500; and a mechanical quality factor (Qm) of at least about 2000 and further teaches a process that involves suspending powders in deionized water and grinding them by ball milling for 16 hours. The resulting thick powder suspension is then dried at 130°C and calcined at 950°C for 3 hours.

Finally, there is known US2019/0189904 A1 describing a piezoelectric device. wherein there is provided a first dry piezoelectric layer (first dry PL) comprising a dielectric material and having a first and a second opposing surface; and then there is provided a first dry electrically conductive layer (first dry ECL-P) that is arranged contiguous to the first opposing surface of the first dry PL, wherein the first dry ECL-P has an electrically conductive material; and particles distributed within the electrically conductive material, wherein the particles have a Young's modulus that is different from the Young's modulus of the electrically conductive material by at least 10% and the particles have a d50 of at least 500 nm and up to 500 µm and a polydispersity coefficient of less than 3. The weight ratio of particles to electrically conductive material is at least 0.01:1 and up to 10:1and where the particles may be silver.

Patent documents US2019/0229255 A1, JP2016163027 A and US2008009572 A1 disclose a piezoelectric composition with barium titanate and a PVA binder where graphite or carbon particles may be contained.

According to the above, a need has been identified to provide a piezoelectric material that can be in the form of sheets where the material comprises graphite and is lead-free and can efficiently generate improved alternative energy and a manufacturing process where the process is simple and with mild conditions at low cost.

In this regard, it is an objective of the present invention to provide said material and a process for its manufacture, wherein the piezoelectric material converted, for example, into sheets comprising graphite and the sheets can generate power efficiently and improved compared to piezoelectric materials that do not contain graphite.

### DESCRIPTION OF THE FIGURES

Figure 1 illustrates the structure formed by the crystals (20) with the graphite (30) within the ceramic composition (10).
Figure 2 shows the piezoelectric ceramic with the contacts created with the conductive copper paint and silicone washer (50).
Figures 3 and 3A show the electric current conduction curve and voltage generated versus the stress on the piezoelectric generator.

### SUMMARY OF THE INVENTION

The present invention refers to a piezoelectric ceramic material comprising graphite and which is lead-free, wherein the material in sheet form can generate alternative energy in an efficient and improved manner. Also the present invention refers to a process for the production of said ceramic and piezoelectric material in sheets under mild production conditions. Wherein the piezoelectric material has any shape according to the mold in which it is made.

### DETAILED DESCRIPTION OF THE INVENTION

In a first aspect, the present invention refers to a piezoelectric material comprising a lead-free ceramic material wherein the ceramic material (10) is a laminate comprising Barium Titanate (BaTiO₃) in ultrafine powder form, graphite in a proportion between 10% and 20% of the base material in the form of fine powder and a binder material which is polyvinyl alcohol (PVA) which is in a proportion from 2.5% to 7.5%, preferably 5% by weight in demineralized water at a temperature of 60°C.

In a second aspect, the present invention refers to a process for obtaining said lead-free material comprising graphite, wherein the material has piezoelectric properties for alternative energy generation, wherein the process comprises the following steps:
a. Provide as base material barium titanate (BaTiO₃) in fine powder form;
b. Add to said base material powdered graphite in a proportion of 10% to 20% with respect to the base material and a binder material that is dissolved in a proportion of 2.5% to 7.5% by weight in demineralized water and at a temperature of 60°C;
c. Homogenize the mixture obtained in step b) until a uniform grayish coloration of the graphite is obtained;
d. Mechanical sieving with vibration separating the solid particles present in the mixture of step c);
e. Reduce the pressure of the mixture obtained in step d) by vacuum for 30 seconds to 60 seconds, preferably between 30 seconds and 40 seconds at a pressure between 3 and 5 Pascal [Pa], eliminating the air inside the mixture
f. Subject the mixture obtained in step e) to pressing inside a die at a force of 100KN and with a pressing speed of 2 KN/second;
g. Perform a demolding or separation of the green ceramic by mechanical vibration;
h. Subject the ceramic (10) obtained in step g) to a firing process in a furnace or muffle with a temperature curve up to a maximum temperature between 1.200°C and 1.300°C for a period of 1 to 2 hours;
i. Sand the surfaces of the ceramic material obtained in step h) with 200 grit sandpaper in order to remove irregularities on both sides of the material, where sanding can be done with normal water;
j. Subject the material obtained in step i) to preheating at 100°C to remove moisture;
k. Apply on the surface of the laminated material a uniform layer of copper-based paint (40) at a temperature of 100°C in order to create electrodes on the faces of the ceramic material and in such a way as to obtain a level of electrical resistance of less than 1 ohm to ensure its higher conductivity;
l. Raise the temperature to 150°C for a period of 2 to 7 minutes, preferably 5 minutes in order to improve adhesion and electrical contact with the surface of the ceramic material;
m. Add a dielectric protection comprising high temperature chemical silicone in the form of a washer (50) on the contour of the laminated material;
n. Polarize the ceramic material obtained in step m) at a temperature between 120°C and 170°C, preferably at 150°C and apply an electrical potential between 10.000V and 20.000V DC for a period of 30 to 70 seconds, preferably 40 seconds and decreasing the temperature from 150°C to 80°C;
o. Cool the ceramic material from step n) to room temperature, which can be from 15°C to 30°C; and
p. Remove the silicone dielectric protection applied in step m) and discharge the ceramic material with a resistance of 1000 ohms at 1W.

The process for obtaining the lead-free material and comprising graphite (30) according to the present invention, may comprise an additional stage q) corresponding to the verification of the piezoelectric properties of the ceramic material obtained from step p) by means of an apparatus measuring the parameter d33, which indicates the amount of energy produced per unit of applied force in units of pC/N.

### BEST WAY TO CARRY OUT THE INVENTION

Prepare the base material which is barium titanate (BaTiO₃) powder which must be free of impurities, fully sieved for what is used a fine sieve also integrates the graphite (30) powder by sieving three times to ensure the homogeneity of the two components, integrates the polyvinyl alcohol which is prepared with distilled water with a temperature 60°C is integrated into the mixture and continues sieving three times to homogenize the whole compound further. The air is extracted with a vacuum pump between 3 and 5 Pascal [Pa].

Then the mixture is placed in a matrix which will determine the dimensions in which the size of the ceramic will be established, it is subjected to a compression of 100KN and with a pressing speed of 2 KN/second. This will result in a green ceramic.

Next, the green ceramic is removed from the matrix and placed on the base of the kiln and the calcining process begins between 1.200°C and 1.300°C where a thermal elevation line is generated to reach 1.200°C in one hour and is sustained for 30 minutes until it reaches 1.300°C and then it drops to room temperature in about one hour.

Then the consolidated ceramic is extracted and the faces of the ceramic are polished to clean any residues or impurities that may have been generated, it is washed with water with a finer grain sandpaper. Subsequently, it is subjected to a moisture release process at 100°C for 20 minutes.

The ceramic obtained is coated on both sides with copper-based conductive paint at a temperature of 150°C, allowing the electrodes to adhere and dry immediately, and the temperature is allowed to drop. The shape of the ceramic is disk-shaped, which guarantees its structural integrity and its dimensions will depend on the matrix used for the pressing process.

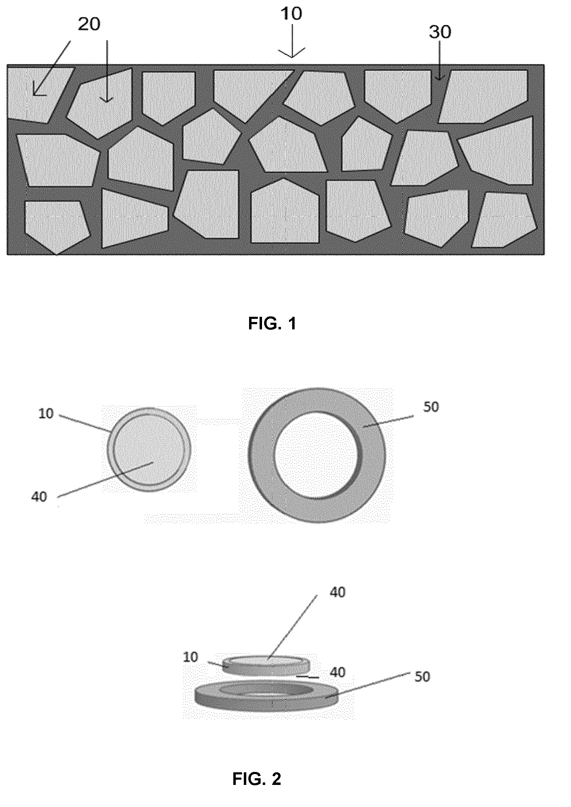

In the polarization process in which the ceramic is added a dielectric protection in silicone on the outside as shown in Figure 2, then starts increasing the temperature between 120°C and 170°C, and applies an electric potential between 10.000 and 20.000 VDC for a period of 30 to 70 seconds which will align the electrical domains of the material and is allowed to descend with this electrical charge until the material is discharged since this, at this moment, will behave as a high voltage capacitor, is performed by joining the two electrical terminals an electrical discharge resistance of 1000 ohms at 1W.

Optionally, the coefficient d33 is verified with piezoelectric properties of the prepared ceramic, which will be greater than 40 pC/N for this one, in addition to verifying its polarization that occurs when the ceramic is turned over, which will show the same value, but with a negative sign.

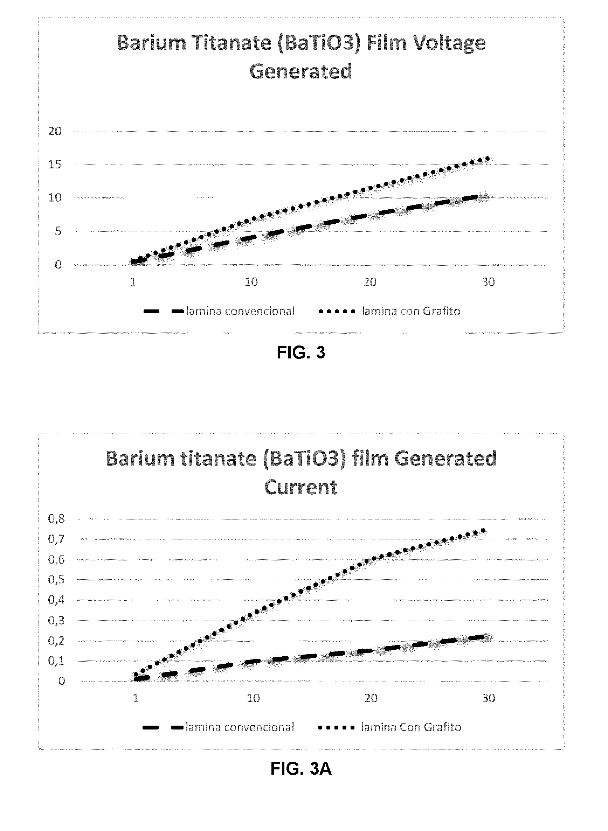

Referring to Figs. 3 and 3A where the results obtained from Table 1 are graphically illustrated, which represents the amount of current in amperes (A) generated and energy in Volts (V) delivered by a generation cell with Barium Titanate (BaTiO3) and another with Barium Titanate (BaTiO3) with Graphite exposed to pressure in Kg of force with a variation time of 0.25 seconds.

Graph 3A shows the increase in electric current conduction in Amperes (A) as the current increases significantly depending on the stress on the piezoelectric generator. As a result it is observed that the ceramic sheet (10) with Graphite (30) of the present invention has a significant increase in electrical current conduction as compared to sheets not containing Graphite.

### ADVANTAGES AND BENEFITS OF THE INVENTION

As an advantage when integrating graphite to the development of the material in the generation of crystals (20) by calcination, an electrically conductive amalgamation between these crystals is generated in addition to an electrically conductive amalgamation between them, which allows for greater electrical conduction when compressing and decompressing the piezoelectric device

When the polarization of the material and the alignment of the domains of the ceramic walls is performed, these will be higher and more ordered because they contain graphite in their structure, allowing the alignment as electric current generation.

Table 1 shows the amount of energy delivered by a generation cell with Barium Titanate (BaTiO₃) and another with Barium Titanate (BaTiO₃) with Graphite exposed to pressure in kf force with a variation time of 0.25 seconds.

**Table 1. The piezoelectric properties of ceramics.**

| Time 0.25 seconds | Barium Titanate (BaTiO₃) | | Barium Titanate (BaTiO₃) With Graphite | |
|---|---|---|---|---|
| Kg of Force | Voltage (V) | Current (A) | Voltage (V) | Current (A) |
| 1 | 0.45 | 0.0112 | 0.62 | 0.0241 |
| 10 | 4.1 | 0.0983 | 6.8 | 0,238 |
| 20 | 7.5 | 0.1522 | 11.5 | 0.4505 |
| 30 | 10.5 | 0.2251 | 16.0 | 0,525 |

Table 1 shows the increase in the electric current conduction in Amperes (A) since the current increases significantly depending on the stress on the piezoelectric generator.

## Claims

1. A piezoelectric transducer comprising:
a pair of electrodes each arranged as a copper-based paint uniform layer (40) on both faces of a laminated ceramic material (10); and
a siliconized washer (50) arranged around the laminated ceramic material (10) for dielectric protection of the same;
a piezoelectric plate composed of the laminated ceramic-base material (10), wherein the laminated ceramic material (10) comprises:
a base material made of piezoelectric ceramic ultrafine powder of barium titanate,
- graphite i in form of powder (30) in a ratio of 10 to 20% with respect to the base material, and a binder material, wherein the binder material consists of water-based polyvinyl alcohol, PVA.

2. A piezoelectric transducer according to claim 1, wherein the binder material is polyvinyl alcohol, PVA, and is dissolved in the base material of barium titanate with graphite.

3. A piezoelectric transducer according to claim 1, wherein the polyvinyl alcohol, PVA, is in a ratio selected from 2,5% to 7,5% by weight in demineralized water.

4. A piezoelectric transducer according to claim 3, wherein the polyvinyl alcohol, PVA, is in a ratio selected from 5% by weight in demineralized water.

5. A piezoelectric transducer according to claim 1, wherein the siliconized washer (50) arranged around the laminated ceramic material (10) is a dielectric barrier comprising silicone.

6. A piezoelectric transducer according to claim 1, wherein the laminated ceramic material (10) further comprises electrically conductive crystals (20) separated and arranged in the graphite (30) of the polarized piezoelectric plate.

7. A process of manufacturing a piezoelectric transducer comprising the steps of:
a) providing fine powder of barium titanate, BaTiO₃, as base material;
b) adding to said base material, graphite in powder in a ratio selected from 10% to 20% regarding the base material and a binder material selected from polyvinyl alcohol, PVA;
c) homogenizing the mixture obtained in step b) until a uniform grayish coloration of the graphite is obtained;
d) sieving mechanically with vibration to separate solid particles present in the mixture of step c);
e) reducing the pressure of the mixture obtained in step d) through vacuum;
f) submitting the mixture obtained in step e) to pressing;
g) demolding or separating the green ceramic;
h) submitting the mixture obtained in step g) to a stoved process in a furnace or muffle;
i) sanding the surfaces of the ceramic material obtained from the step h) to remove unevenness on both faces of the material;
j) submitting the material obtained in previous step i) to preheating to remove humidity;
k) applying on the surface of the laminated material obtained in the previous step a copper-based paint to create electrodes on the ceramic material faces;
l) increasing the temperature to improve adhesion and electrical contact to the ceramic material surface;
m) adding a dielectric barrier comprising silicone in form of a washer around the laminated material;
n) polarizing the ceramic material obtained from step m) by applying an electric potential;
o) cooling the ceramic material obtained from step n); and
p) removing the silicone dielectric barrier applied in step m) and discharging the ceramic material.

8. The process according to claim 7, **characterized in that** in step n) the electric potential is selected between 10.000V and 20.000V DC, applied during 30 to 70 seconds at a temperature selected between 120 °C and 170 °C and then the temperature is decreased to 80°C.

9. The process according to claim 7, **characterized in that** in step o) the cooling temperature is room temperature ranging from 15 °C to 30 °C.

10. The process according to claim 7, **characterized in that** in step p) the discharging of the ceramic material is with a resistance of 1000 ohms at 1W.

11. The process according to any of the preceding claims, **characterized in that** it further comprises step q) verifying the ceramic material piezoelectric properties through measuring of coefficient d33, which indicates the amount of energy produced per unit of applied force in units of pC/N.

## Patentansprüche

1. Piezoelektrischer Wandler, umfassend:
ein Paar Elektroden, die jeweils als gleichmäßige Schicht (40) aus einem kupferbasierten Lack auf beiden Flächen eines laminierten Keramikmaterials (10) angeordnet sind; und eine silikonisierte Unterlegscheibe (50), die zum dielektrischen Schutz des laminierten Keramikmaterials (10) um dieses herum angeordnet ist;
eine piezoelektrische Scheibe, bestehend aus dem laminierten keramischen Grundmaterial (10), wobei das laminierte Keramikmaterial (10) Folgendes umfasst:
ein Grundmaterial aus feinpulverförmiger piezoelektrischer Bariumtitanat-Keramik, Graphit in Pulverform (30) mit einem Anteil von 10 bis 20 % bezogen auf das Grundmaterial und ein Bindemittel, wobei das Bindemittel aus wasserbasiertem Polyvinylalkohol (PVA) besteht.

2. Piezoelektrischer Wandler nach Anspruch 1, wobei das Bindemittel aus Polyvinylalkohol (PVA) besteht und in dem Bariumtitanat-Grundmaterial mit Graphit gelöst ist.

3. Piezoelektrischer Wandler nach Anspruch 1, wobei der Polyvinylalkohol (PVA) in einem Gewichtsanteil von 2,5 % bis 7,5 % in entmineralisiertem Wasser vorliegt.

4. Piezoelektrischer Wandler nach Anspruch 3, wobei der Polyvinylalkohol (PVA) in einem Gewichtsanteil von 5 % in entmineralisiertem Wasser vorliegt.

5. Piezoelektrischer Wandler nach Anspruch 1, wobei die um das laminierte Keramikmaterial (10) angeordnete silikonisierte Unterlegscheibe (50) eine silikonhaltige dielektrische Barriere ist.

6. Piezoelektrischer Wandler nach Anspruch 1, wobei das laminierte Keramikmaterial (10) ferner elektrisch leitfähige Kristalle (20) umfasst, die voneinander getrennt im Graphit (30) der polarisierten piezoelektrischen Scheibe angeordnet sind.

7. Verfahren zur Herstellung eines piezoelektrischen Wandlers, das die folgenden Schritte umfasst:
a) Bereitstellen von feinpulverförmigem Bariumtitanat (BaTiO₃) als Grundmaterial;
b) Hinzufügen von Graphitpulver in einem Anteil von 10 % bis 20 %, bezogen auf das Grundmaterial, sowie eines Bindemittels, ausgewählt aus Polyvinylalkohol (PVA), zu dem genannten Grundmaterial;
c) Homogenisieren der in Schritt b) erhaltenen Mischung, bis eine gleichmäßige grauartige Färbung des Graphits entsteht;
d) mechanisches Sieben durch Vibration zum Abtrennen der in der Mischung aus Schritt c) vorhandenen Feststoffpartikel;
e) Verringern des Drucks der in Schritt d) erhaltenen Mischung mittels Vakuum;
f) Pressen der in Schritt e) erhaltenen Mischung;
g) Entformen oder Trennen des Keramikgrünlings;
h) Brennen der in Schritt g) erhaltenen Mischung in einem Ofen oder Muffelofen;
i) Schleifen der Oberflächen des in Schritt h) erhaltenen Keramikmaterials zur Beseitigung von Unebenheiten auf beiden Flächen des Materials;
j) Vorwärmen des in Schritt i) erhaltenen Materials zur Entfernung von Feuchtigkeit;
k) Aufbringen eines kupferbasierten Lacks auf die Oberfläche des im vorstehenden Schritt erhaltenen laminierten Materials zum Erzeugen von Elektroden auf den Flächen des Keramikmaterials;
l) Erhöhen der Temperatur zur Verbesserung der Haftung auf und des elektrischen Kontakts mit der Oberfläche des Keramikmaterials;
m) Anbringen einer silikonhaltigen dielektrischen Barriere in Form einer Unterlegscheibe um das laminierte Material herum;
n) Polen des in Schritt m) erhaltenen Keramikmaterials durch Anlegen einer elektrischen Spannung;
o) Abkühlen des in Schritt n) erhaltenen Keramikmaterials; und
p) Entfernen der in Schritt m) aufgebrachten silikonhaltigen dielektrischen Barriere und Entnehmen des Keramikmaterials.

8. Verfahren nach Anspruch 7, **dadurch gekennzeichnet, dass** die elektrische Spannung in Schritt n) zwischen 10.000 V und 20.000 V Gleichspannung beträgt und 30 bis 70 Sekunden lang bei einer Temperatur zwischen 120 °C und 170 °C angelegt wird, bevor die Temperatur auf 80 °C gesenkt wird.

9. Verfahren nach Anspruch 7, **dadurch gekennzeichnet, dass** die Abkühltemperatur in Schritt o) einer Raumtemperatur im Bereich von 15 °C bis 30 °C entspricht.

10. Verfahren nach Anspruch 7, **dadurch gekennzeichnet, dass** das Entnehmen des Keramikmaterials in Schritt p) bei einem Widerstand von 1.000 Ohm und einer Leistung von 1 W erfolgt.

11. Verfahren nach einem der vorstehenden Ansprüche, **dadurch gekennzeichnet, dass** es ferner einen Schritt q) des Überprüfens der piezoelektrischen Eigenschaften des Keramikmaterials durch Messung des Koeffizienten d₃₃ umfasst, wobei d₃₃ die pro Einheit der aufgebrachten Kraft erzeugte Energiemenge in pC/N angibt.

## Revendications

1. Transducteur piézoélectrique comprenant :
une paire d'électrodes disposées chacune sous la forme d'une couche uniforme de peinture à base de cuivre (40) sur chacune des deux faces d'un matériau céramique laminé (10) ; et une rondelle siliconée (50) disposée autour du matériau céramique laminé (10) pour assurer la protection diélectrique de celui-ci ;
une plaque piézoélectrique composée du matériau laminé à base de céramique (10), dans lequel le matériau céramique laminé (10) comprend :
un matériau de base constitué de poudre ultrafine de céramique piézoélectrique de titanate de baryum, du graphite sous forme de poudre (30) dans une proportion de 10 à 20 % par rapport au matériau de base, et un matériau liant, dans lequel le matériau liant est constitué d'alcool polyvinylique, PVA, en solution aqueuse.

2. Transducteur piézoélectrique selon la revendication 1, dans lequel le matériau liant est de l'alcool polyvinylique, PVA, et est dissous dans le matériau de base de titanate de baryum contenant du graphite.

3. Transducteur piézoélectrique selon la revendication 1, dans lequel l'alcool polyvinylique, PVA, est présent dans une proportion choisie dans la plage de 2,5 % à 7,5 % en poids dans de l'eau déminéralisée.

4. Transducteur piézoélectrique selon la revendication 3, dans lequel l'alcool polyvinylique, PVA, est présent dans une proportion choisie de 5 % en poids dans de l'eau déminéralisée.

5. Transducteur piézoélectrique selon la revendication 1, dans lequel la rondelle siliconée (50) disposée autour du matériau céramique laminé (10) est une barrière diélectrique comprenant du silicone.

6. Transducteur piézoélectrique selon la revendication 1, dans lequel le matériau céramique laminé (10) comprend en outre des cristaux électriquement conducteurs (20) séparés et disposés dans le graphite (30) de la plaque piézoélectrique polarisée.

7. Procédé de fabrication d'un transducteur piézoélectrique comprenant les étapes consistant à :
a) fournir une poudre fine de titanate de baryum, BaTiO3, en tant que matériau de base ;
b) ajouter audit matériau de base du graphite en poudre dans une proportion choisie dans la plage de 10 % à 20 % par rapport au matériau de base et un matériau liant choisi parmi l'alcool polyvinylique, PVA ;
c) homogénéiser le mélange obtenu à l'étape b) jusqu'à l'obtention d'une coloration grisâtre uniforme du graphite ;
d) effectuer un tamisage mécanique par vibration pour séparer les particules solides présentes dans le mélange de l'étape c) ;
e) réduire la pression du mélange obtenu à l'étape d) par mise sous vide ;
f) soumettre le mélange obtenu à l'étape e) à un pressage ;
g) démouler ou séparer la céramique crue ;
h) soumettre le mélange obtenu à l'étape g) à un procédé d'étuvage dans un four ou un four à moufle ;
i) poncer les surfaces du matériau céramique obtenu à l'étape h) pour éliminer les irrégularités sur les deux faces du matériau ;
j) soumettre le matériau obtenu à l'étape précédente i) à un préchauffage pour éliminer l'humidité ;
k) appliquer sur la surface du matériau laminé obtenu à l'étape précédente une peinture à base de cuivre pour créer des électrodes sur les faces du matériau céramique ;
l) augmenter la température pour améliorer l'adhérence et le contact électrique avec la surface du matériau céramique ;
m) ajouter une barrière diélectrique comprenant du silicone sous forme de rondelle autour du matériau laminé ;
n) polariser le matériau céramique obtenu à l'étape m) en appliquant un potentiel électrique ;
o) refroidir le matériau céramique obtenu à l'étape n) ; et
p) retirer la barrière diélectrique en silicone appliquée à l'étape m) et décharger le matériau céramique

8. Procédé selon la revendication 7, **caractérisé en ce qu'**à l'étape n), le potentiel électrique est choisi dans la plage de 10 000 V à 20 000 V DC, appliqué pendant une durée de 30 à 70 secondes à une température choisie dans la plage de 120 °C à 170 °C, puis la température est abaissée à 80 °C.

9. Procédé selon la revendication 7, **caractérisé en ce qu'**à l'étape o), la température de refroidissement est la température ambiante comprise dans la plage de 15 °C à 30 °C.

10. Procédé selon la revendication 7, **caractérisé en ce qu'**à l'étape p), la décharge du matériau céramique est effectuée au moyen d'une résistance de 1000 ohms à 1 W.

11. Procédé selon l'une quelconque des revendications précédentes, **caractérisé en ce qu'**il comprend en outre une étape q) consistant à vérifier les propriétés piézoélectriques du matériau céramique par mesure du coefficient d33, qui indique la quantité d'énergie produite par unité de force appliquée, en unités de pC/N.
